(19) Europäisches Patentamt
European Patent Office
Office européen des brevets

(11) **EP 2 926 383 B1**

(12) **EUROPÄISCHE PATENTSCHRIFT**

(45) Veröffentlichungstag und Bekanntmachung des Hinweises auf die Patenterteilung:
**14.12.2016  Patentblatt 2016/50**

(21) Anmeldenummer: **13774131.0**

(22) Anmeldetag: **07.10.2013**

(51) Int Cl.:
*H01L 41/09* (2006.01)    *H01L 41/113* (2006.01)
*H01L 41/193* (2006.01)    *H04R 17/00* (2006.01)
*H04R 17/02* (2006.01)    *H04R 19/01* (2006.01)

(86) Internationale Anmeldenummer:
**PCT/EP2013/070769**

(87) Internationale Veröffentlichungsnummer:
**WO 2014/082777 (05.06.2014 Gazette 2014/23)**

(54) **WANDLER MIT ZUMINDEST EINER ELEKTRODE EINES ERSTEN TYPS, EINER ELEKTRODE EINES ZWEITEN TYPS UND ZUMINDEST EINEM FERROELEKTRET**

TRANSDUCER HAVING AT LEAST ONE ELECTRODE OF A FIRST TYPE, ONE ELECTRODE OF A SECOND TYPE AND AT LEAST ONE FERROELECTRET

CONVERTISSEUR PRÉSENTANT AU MOINS UNE ÉLECTRODE D'UN PREMIER TYPE, UNE ÉLECTRODE D'UN DEUXIÈME TYPE ET AU MOINS UN FERROÉLECTRET

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.11.2012  DE 102012221833**

(43) Veröffentlichungstag der Anmeldung:
**07.10.2015  Patentblatt 2015/41**

(73) Patentinhaber: **Robert Bosch GmbH**
**70442 Stuttgart (DE)**

(72) Erfinder:
• **BARTYLLA, David**
**71229 Leonberg (DE)**

• **HILLENBRAND, Joachim**
**64291 Darmstadt (DE)**

(56) Entgegenhaltungen:
EP-A1- 2 339 869        DE-A1- 2 253 721
DE-A1-102006 002 067    US-A- 4 183 010
US-A1- 2009 245 547

• **HILLENBRAND ET AL: "Voltage sensitivity of electret- and piezoelectret-accelerometers", ELECTRETS, 28. August 2011 (2011-08-28), Seiten 203-204, XP032000145, DOI: 10.1109/ISE.2011.6085053 ISBN: 978-1-4577-1023-0**

## Beschreibung

Stand der Technik

Die Erfindung betrifft einen Wandler mit zumindest einer Elektrode des ersten Typs, einer Elektrode eines zweiten Typs und zumindest einem Ferroelektret.

Seit etwa einem Jahrzehnt werden in der Forschung verstärkt poröse Polymerfolien, beispielsweise unter dem Handelsnamen Emfi von Emfit Ltd. erhältlich, so genannte Ferroelektrete untersucht und in unterschiedlichen, auch akustischen Anwendungen eingesetzt. Die Ferroelektrete sind piezoelektrisch und weisen Piezokonstanten auf, die mit denen von Blei-Zirkonat-Titanat-Piezoelektrika (PZT) vergleichbar sind. Ferroelektrika verhalten sich, von außen betrachtet, idealerweise exakt wie herkömmliche Piezoelektrika, allerdings wird der externe Piezoeffekt durch unzählige innere Elektreteffekte erzeugt. Daher stammt auch der Name Ferroelektrete, die auch als Piezoelektrete bezeichnet sein können.

DE 10 2006 002 067 A1 zeigt einen Empfänger eines Ultraschallsensors, von dem Empfangselektroden parallel zu einer Bodenelektrode angeordnet sind und bei dem sich zwischen den Empfangselektroden und der Bodenelektrode ein piezoelektrischer Komplex befindet. Der piezoelektrische Komplex kann beispielsweise eine Mehrzahl von Piezoelementen aus einer ferroelektrischen Substanz wie etwa PZT aufweisen, und eine Mehrzahl von Schichten aus einem organischen Polymer.

EP 2 339 869 A1 zeigt ein Verfahren zur Herstellung von Zwei- oder Mehrschicht-Ferroelektreten mit definierten Hohlräumen. Die Ferroelektrete werden zum Beispiel im elektromechanischen und elektroakustischen Bereich angewendet.

US 4 183 010 zeigt ein als Sensor verwendetes Kabel, welches Elektrete und Ferroelektrete kombinieren, wobei das Elektret durch einen Luftspalt von einer geteilten Elektrode getrennt ist.

DE 2 253 721 zeigt einen ähnlichen Aufbau beispielsweise für ein Mikrophon.

In vielen elektronischen Geräten finden sich heute außerdem Wandler, d. h. Sensoren und Aktoren auf Basis von Elektreten. Stückzahlen bei der Herstellung von Elektretmikrofonen übertreffen in einigen Gebieten der Technik jene von Siliziummikrofonen.

Im Stand der Technik funktionieren Sensoren und Aktoren entweder auf Basis des Elektreteffekts oder auf Basis des Piezoeffekts, beispielsweise auf dem angesprochenen Piezoeffekt von Ferroelektreten. Konstruktionsbedingt gibt es in jedem Wandler ungenützte Bereiche und Flächen, die nicht zum Elektret- bzw. Piezoeffekt beitragen, was zu einer nicht optimalen Empfindlichkeit des Wandlers führt.

Offenbarung der Erfindung

Anspruch 1 spezifiziert einen ersten Aspekt der Erfindung. Es wird ein Wandler mit zumindest einer Elektrode eines ersten Typs, zumindest einer Elektrode eines zweiten Typs, zumindest einem Ferroelektret und zumindest einem Elektret vorgeschlagen, wobei die Elektrode des ersten Typs mit dem Ferroelektret leitend verbunden ist, das Elektret zur Elektrode des ersten Typs durch zumindest einen Luftspalt beabstandet ist und das Elektret und das Ferroelektret mit der Elektrode des zweiten Typs leitend verbunden sind.

Die erfindungsgemäße Anordnung hat den Vorteil, dass der Elektreteffekt und der Piezoeffekt in einem Wandler kombiniert werden. Hierdurch kann ein Wandler mit verbesserten Eigenschaften erhalten werden, da das dem Wandler zur Verfügung stehende Volumen und die zur Verfügung stehende Fläche effektiver genutzt werden können. Das Elektret und das Piezoelektret werden hierzu elektrisch entweder in Reihe oder parallel geschaltet. Für einen Sensor addieren sich im ersten Fall die Ausgangsspannungen der beiden Bereiche, d. h. des Elektretbereichs und des Piezobereichs, und im zweiten Fall die Ladungen bzw. die Ströme. Besonders vorteilhaft ist, dass sich hierdurch die Empfindlichkeit des Sensors und auch der Signal-Rausch-Abstand erhöhen lassen. Durch die Kombination der beiden Prinzipien, Elektreteffekt und Ferroelektreteffekt, wird das detektierte Signal verstärkt und das Potential des Wandlers voll ausgeschöpft.

Ein besonderer Vorteil ist, dass die Ausfallsicherheit des Wandlers erhöht ist. Im Fall des Elektrets kann beispielsweise durch eine Übertragung der negativen Ladung auf die obere Elektrode ein Kurzschluss entstehen. Für den Fall, dass das Elektret defekt ist, indem beispielsweise eine Berührung der Elektrode des ersten Typs mit dem Elektret durch Überbrückung des Luftspalts stattgefunden hat, ist durch Auswertung der Schwingungen am Ferroelektret ein noch voll aussagefähiges oder zumindest eingeschränkt aussagefähiges Signal abnehmbar. Wenn sich also eines der aktiven Elemente, etwa das Ferroelektret oder das Elektret entlädt, kann das andere weiter funktionieren.

Das Elektret ist nach einer besonders bevorzugten Ausführungsform aus einem porösen Polymer gefertigt. Wenn es geladen wurde, weist es eine erhöhte Ladungsstabilität über Temperaturwechsel und die Zeit auf. Befindet sich das Elektret zwischen den Elektroden, dann bildet sich im Prinzip ein Kondensatormikrofon, das keinerlei elektrische Vorspannung benötigt. Trifft Schall auf eine der beiden Elektroden, so verschieben sich diese und beginnen zu schwingen, wodurch sich der Abstand zwischen der Elektrode und der Gegenelektrode verändert und damit auch die Kapazität, die sich im Falle planparalleler Elektroden beispielsweise gemäß

$$C = \varepsilon \, \frac{A}{d} \ \text{berechnet,}$$

wobei C die Kapazität des Kondensators,

ε das dielektrische Moment,

A die Elektretfläche und

d den Abstand der Kondensatorplatten zueinander bezeichnen. Die durch die Abstandsänderungen zwischen der beweglichen Membran und der Gegenelektrode hervorgerufenen Kapazitätsänderungen werden genutzt, um den Schalldruck oder die Schallschnelle in ein elektrisches Signal umzuwandeln. Im Kondensatormikrophon, wie auch im Wandler, welcher als Sensor fungiert, wird die Kapazitätsänderung verstärkt und detektiert.

Das Ferroelektret funktioniert im Rahmen der Erfindung als bekanntes piezoelektrisches Wandlerelement. Das Ferroelektret kann auch kurz als Piezoelement bezeichnet sein, weist aber leicht veränderte Eigenschaften gegenüber einem klassischem Piezoelement auf, beispielsweise eine nicht zu stark ausgeprägte Piezoaktivität parallel zur Hauptfläche. Das Ferroelektret ist ebenfalls beispielsweise aus einem porösen Polymer gefertigt. Durch eine Aufladung, z. B. mittels Corona, wird die Luft in den Blasen geladen. Verändert sich durch Anlegen einer Spannung an Elektrode und Gegenelektrode die Blasenhöhe, so verschieben sich die Ladungen. Diese Verschiebung ist genauso wie bei dem Elektret anschließend verstärkbar und detektierbar.

Durch die in den abhängigen Ansprüchen aufgeführten Maßnahmen sind vorteilhafte Weiterbildungen und Verbesserungen der im unabhängigen Anspruch angegebenen Vorrichtung möglich.

Nach einer Ausführungsform der Erfindung ist das Ferroelektret in einem Randbereich der Elektrode des ersten Typs angeordnet. Der Randbereich kann beispielsweise etwa 1% bis 50%, bevorzugt zwischen 5% und 20% der Hauptfläche der Elektrode oder des Wandlers ausmachen. Der Randbereich kann dabei durch einen Bereich definiert sein, welcher sich vom Umfang der Elektrode äquidistant nach innen bemisst. Bei dieser Anordnung sind die Schwingungen im Randbereich der Elektroden durch das Ferroelektret besonders gut aufnehmbar. Besonders vorteilhaft ist, wenn das Ferroelektret die Elektrode des ersten Typs gegen das Elektret abstützt, so dass Randabstützungen über weiteren Bauteilen, beispielsweise nicht elektrisch aktive Bauteile nicht nötig sind.

Besonders bevorzugt ist das Elektret in dieser Ausführungsform im Zentrum der Elektrode des ersten Typs angeordnet. Das Ferroelektret umgibt das Elektret dabei ringförmig, wobei dies für radialsymmetrische Wandler ebenso wie für Wandler mit elliptischem, rechteckigem, quadratischem oder allgemein mit durch einen Polygonzug begrenztem Umfang gelten kann. Alternativ hierzu können auch Aussparungen im Ferroelektret möglich sein oder es können mehrere Ferroelektretenblöcke vorgesehen sein, die das Elektret umgeben.

Nach einer alternativen Ausführungsform ist das Ferroelektret im Zentrum der Elektrode des ersten Typs angeordnet. In dieser Ausführungsform ist die Kopplung des Ferroelektrets zur Hauptschwingungsmode optimal. Das Elektret umgibt in diesem Fall das Ferroelektret beispielsweise ringförmig.

Gemäß einem weiteren Aspekt der Erfindung wird ein Ultraschallwandler vorgeschlagen, welcher einen der oben beschriebenen Wandler aufweist. Der vorgeschlagene Ultraschallwandler bietet aufgrund der parallel geschalteten Elektreten und Ferroelektreten eine besondere mechanische Stabilität bei gleichbleibender Signalqualität und Funktionstoleranzen.

Der Ultraschallwandler kann beispielsweise als Durchflussmesser in der Verfahrenstechnik oder im Automobilbereich, insbesondere im Ansaug- und/oder Abgastrakt von Verbrennungsmotoren zur Volumen- oder Massenstrommessung eingesetzt werden oder als Umfeldsensor, insbesondere im vorderen und/oder hinteren Stoßfänger des Fahrzeugs, beispielsweise zum Zwecke der Parkassistenz und/oder Kollisionsvermeidung. Ein derartiger Ultraschallwandler kann im Betriebszustand Ultraschallwellen in ein fluides Medium, beispielsweise Luft, Gas und/oder eine Flüssigkeit emittieren und/oder Ultraschallwellen empfangen. In derartigen Einsatzgebieten werden Ultraschallsignale üblicherweise durch das fluide Medium von einem Emitter zu einem Empfänger übermittelt oder von einem Emitter in eine Umgebung übermittelt und von einem in der Umgebung befindlichen Objekt reflektierte Ultraschallsignale erfasst und die Laufzeit und/oder Laufzeitdifferenzen und/oder weitere Größen wie beispielsweise Amplituden oder Phasen der Ultraschallsignale empfangen und gemessen. Weitere Einsatzgebiete des Ultraschallwandlers können etwa Ultraschall in der Robotik sein oder als Beschleunigungsaufnehmer.

Gemäß einem weiteren Aspekt der Erfindung wird ein Mikrofon vorgeschlagen, das einen der oben beschriebenen Wandler umfasst. Das Mikrophon ist bevorzugt ein Elektretmikrofon und funktioniert als ein elektroakustischer Wandler, der Schall in ein entsprechendes elektrisches Signal umwandelt. Bei dem Mikrofon ist bevorzugt das Ferroelektret am Randbereich der Elektrode des ersten Typs angeordnet und das Elektret im Zentrum der Elektrode des ersten Typs angeordnet. Auf diese Weise ist vorteilhaft ein niederfrequenter Bereich erreichbar.

Kurze Beschreibung der Zeichnungen

Ausführungsbeispiele der Erfindung sind in den Zeichnungen dargestellt und in der nachfolgenden Beschreibung näher erläutert. Es zeigen

Fig. 1 eine Anordnung mit einer Elektrode eines ersten Typs, einer Elektrode eines zweiten Typs, einem Elektret und einem Ferroelektret nach einer ersten Ausführungsform in Schnittansicht,

Fig. 2 eine Anordnung mit einer Elektrode eines ersten Typs, einer Elektrode eines zweiten Typs, einem Elektret und einem Ferroelektret nach einer zweiten Ausführungsform in Schnittansicht und

Fig. 3 eine Anordnung mit einer Elektrode eines ersten Typs, einer Elektrode eines zweiten Typs, einem Elektret und einem Ferroelektret nach einer dritten Ausführungsform in Schnittansicht.

Ausführungsformen der Erfindung

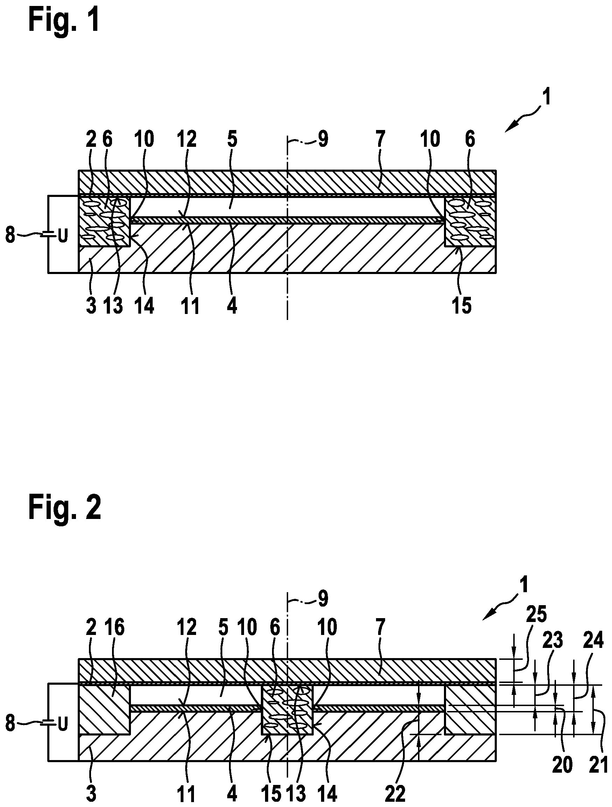

Fig. 1 zeigt einen Wandler 1, beispielsweise einen Sensor oder einen Aktor, gemäß einer ersten Ausführungsform der Erfindung von der Seite in Schnittansicht, welcher durch eine Anordnung mit einer Elektrode des ersten Typs 2, einer Elektrode des zweiten Typs 3, einem Elektret 4, welcher durch einen Luftspalt 5 von der Elektrode des ersten Typs 2 getrennt ist, einem Ferroelektret 6 und einer Deckschicht 7 definiert ist. Die Deckschicht 7 liegt vollflächig auf der Elektrode des ersten Typs 2 auf.

Eine Spannungsquelle 8 ist an die Elektrode des ersten Typs 2 und andererseits an die Elektrode des zweiten Typs 3 angeschlossen. Der Wandler 1 kann in Draufsicht verschiedene Geometrien aufweisen, beispielsweise radialsymmetrisch oder elliptisch um eine Hauptachse 9 sein, aber auch eine quaderförmige, kubische oder zylindrische Geometrie aufweisen. Das Ferroelektret 6 ist hierbei ringförmig oder elliptisch um das Elektret 4 angeordnet.

In Draufsicht (nicht dargestellt), kann die Fläche des Elektrets 4 zur Fläche des Ferroelektrets 6 ein Verhältnis aufweisen, welches zwischen 1:100 und 100:1 liegt. Eine optimale Anpassung findet bezogen auf den Praxisfall statt. Ein breites Ferroelektret weist eine hohe Steifigkeit auf und erhöht die Resonanzfrequenz. Bevorzugt sind etwa 5% bis 50% der Randfläche des Wandlers 1 (in Draufsicht) vom Ferroelektret 6 ausgefüllt und die restliche Fläche vom Elektret 4.

Das Elektret 4 ist zentrisch bezüglich einer Hauptachse 9, d. h. im Zentrum der Elektroden und insbesondere im Zentrum der Deckschicht 7 angeordnet, und somit optimal an die Hauptschwingungsmode der Dickenschwingung der Deckschicht 7 des Wandlers 1 gekoppelt. Es ergeben sich unterschiedliche resonante Schwingungsmoden, die je nach Geometrie mehr oder weniger ausgeprägt sind, bzw. untereinander unterschiedlich ge- oder entkoppelt sind. Bei einfachen quaderförmigen oder zylindrischen Geometrien ergeben sich vor allem Dickenschwingungen der Deckschicht 7, Längsschwingungen des Deckschichtzylinders longitudinal, Scherschwingungen und Längsschwingungen transversal, die alle zumindest prinzipiell zur Wandlung beispielsweise von Ultraschall eingesetzt werden können. Eine reine Ausprägung der Dickenschwingung der Deckschicht 7 tritt insbesondere dann auf, wenn die Deckschicht 7 in dem Frequenzbereich als starr angenommen werden kann.

Für die einzelnen Schwingungsformen existieren jeweils unterschiedliche, materialabhängige Frequenzkonstanten, aus denen sich z. B. für die planar schwingende Platte die Resonanzfrequenz als antiproportional zur Dicke berechnen lässt. Abweichend von den genannten Geometrieverhältnissen, die beim Wandler 1 zu den oben beschriebenen reinen Schwingungsformen führen, können im Gesamtverbund andere Geometrien vorteilhaft sein.

Die in Fig. 1 dargestellte Ausführungsform ist besonders vorteilhaft bei einem Mikrofon einsetzbar, kann aber auch als Ultraschallwandler beispielsweise zur Erfassung einer Fahrzeugumgebung realisiert sein.

Das Elektret 4 ist als eine dünne Scheibe auf der Oberfläche der Elektrode des zweiten Typs 3 angeordnet und weist eine gemeinsame Grenzfläche 11 mit dieser auf. Die andere Hauptseite 12 des Elektrets 4 ist an einen Luftspalt 5 gekoppelt, welcher das Elektret 4 von der Elektrode des ersten Typs 2 beabstandet. Außerdem weist das Ferroelektret 6 innenseitig eine gemeinsame Grenzfläche 10 mit dem Elektret 4 auf.

Das Ferroelektret 6 weist eine gemeinsame Grenzfläche 13 mit der Elektrode des ersten Typs 2 und eine gemeinsame Grenzfläche 14 mit der Elektrode des zweiten Typs 3 auf. Über die gemeinsamen Grenzflächen 13, 14 ist das Ferroelektret 6 leitend zwischen die erste 2 und zweite 3 Elektrode geschaltet. Im dargestellten Ausführungsbeispiel ist das Ferroelektret 6 in die Elektrode des zweiten Typs 3 versenkt und somit nicht nur seitlich über die erste Fläche 14 mit der Elektrode des zweiten Typs 3 verbunden, sondern auch bodenseitig über eine Fläche 15.

Das Elektret 4 und das Ferroelektret 6 bestehen bevorzugt aus einem porösen Polymermaterial, insbesondere aus PP, FEP, PTFA, PFA oder PTFE oder einer Kombination daraus. Im Falle des Elektrets wird FEP, PTFA, PFA oder PTFE oder eine Kombination daraus bevorzugt verwendet.

Die Deckschicht 7 kann aus einem beliebigen, für den Anwendungszweck angepassten Material bestehen, insbesondere aus einem Glasfaserkunststoffverbund, einem Kohlefaserkunststoffverbund, aus Aluminium, aus einer Keramik oder aus einer Kombination daraus gefertigt sein. Beispielsweise kann die Deckschicht 7 aus einem von der Firma Dupont unter dem Handelsnamen Kapton erhältlichen Polyimid, oder aus von der Firma Dupont unter dem Handelsnamen Mylar erhältlicher biaxial orientierter Polyester-Folie ("boPET") gefertigt sein.

Die Deckschicht 7 kann biegesteif oder biegeweich sein. Die Deckschicht 7 ist bevorzugt derart steif ausgeführt, dass sie Steinschläge und hohe Drücke im Einsatz als Ultraschallwandler aushält. Im Falle des Einsatzes des Wandlers 1 als Mikrofon ist die Deckschicht 7 ausreichend biegeweich ausgeführt, so dass die Kopplung zu niederfrequenten Schwingungsmoden ausgeprägt ist.

Fig. 2 zeigt ein weiteres Ausführungsbeispiel eines Wandlers 1 mit einer Elektrode des ersten Typs 2, einer Elektrode des zweiten Typs 3, einem Elektret 4, welcher über einen Luftspalt 5 von der Elektrode des ersten Typs 2 beabstandet ist, einem Ferroelektret 6 und einer Deckschicht 7. Wie mit Bezug zu Fig. 1 beschrieben, können mit Bezug zu der aus der Zeichenebene heraus stehenden Dimension verschiedene Geometrien vorgesehen sein, wobei radialsymmetrische oder elliptische, aber auch quaderförmige bevorzugt sind.

Das Ferroelektret 6 ist in diesem Ausführungsbeispiel im Zentrum des Wandlers 1, d. h. zentrisch bezüglich der Hauptachse 9 des Wandlers 1 angeordnet. Das Elektret 4 umgibt das Ferroelektret 6 in diesem Ausführungsbeispiel ringförmig oder elliptisch. Das Ferroelektret 6 weist eine gemeinsame Grenzfläche 10 mit dem Elektret 4 auf, welche umfänglich um das Ferroelektret 6 angeordnet ist. Das Ferroelektret 6 weist außerdem eine Grenzfläche 13 zur Elektrode des ersten Typs 2 und eine Grenzfläche 14, 15 zur Elektrode des zweiten Typs 3 auf. Dargestellt ist außerdem ein Abstützring 16, welcher insbesondere zur Beabstandung des Elektrets 4 von der Elektrode des ersten Typs 2 dient.

Mit Bezug zu Fig. 2 werden bevorzugte Dickenverhältnisse und Geometrien beschrieben, welche auf die in Fig. 1 dargestellte Ausführungsform entsprechend übertragbar sind.

Das Elektret 4 ist eine dünne Polymerfolie mit einer Dicke 20, welche im Bereich von 10 bis 100 $\mu$m liegt.

Das Ferroelektret 6 weist eine Dicke 21 von 90 $\pm$ 50 $\mu$m auf. Das Ferroelektret 6 ist zum Teil in die Elektrode des zweiten Typs 3 eingebettet. Die Einbettungstiefe 22 des Ferroelektrets 6 in die Elektrode des zweiten Typs 3 kann zwischen 1% und 99%, bevorzugt zwischen 5% und 50%, besonders bevorzugt zwischen 10% und 30% sein. Die Einbettungstiefe 22 ist in Abhängigkeit der Spezifikation festgelegt. Die Einbettungstiefe 22 des Ferroelektrets 6 ist so ausgelegt, dass die Anforderungen an die Lebensdauer, d. h. an die Festigkeit der Verbindung, und an die gewünschte Empfindlichkeit der Schalldetektion erfüllt werden.

Der Abstand 24 der Elektrode des ersten Typs 2 zur Elektrode des zweiten Typs 3 ist kleiner als 50 $\mu$m, bevorzugt im Bereich von 5 bis 30 $\mu$m. Der Abstand 24 beträgt idealerweise 10 $\mu$m.

Die Dicke 25 der Deckschicht 7 beträgt abhängig vom Material und von der gewünschten Resonanzfrequenz ca. 400 bis 500 $\mu$m. Bei Frequenzen höher als 50 kHz kann die Dicke 25 der Deckschicht weiter erhöht sein, etwa um bis zu 400 $\mu$m. Im Falle von Kapton könnte die Dicke 25 dagegen auch niedriger sein, beispielsweise wäre mit einer Dicke von 25 $\mu$m bereits 50 kHz erreichbar. Für den Fall, dass die Deckschicht 7 als Kohlefaserkunststoffverbund ausgeführt ist, beträgt die Dicke 25 der Deckschicht 7 zwischen 100 $\mu$m und 300 $\mu$m und bevorzugt 200 $\mu$m.

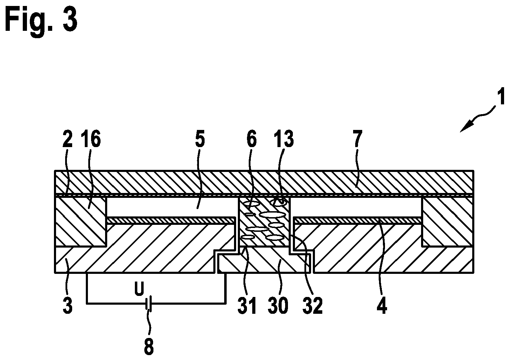

Fig. 3 zeigt eine alternative Ausführungsform des Wandlers 1, wie er in Anspruch 2 spezifiziert ist, bei welchem das Elektret 4 und das Ferroelektret 6 miteinander in Reihe geschaltet sind. Hierzu ist das Ferroelektret 6 von der Elektrode des zweiten Typs 3 mittels einer Isolationsschicht 32 isoliert angeordnet und weist eine gemeinsame Grenzfläche 31 mit einer dritten Elektrode 30 auf. Die Spannungsquelle 8 ist einerseits an die Elektrode des zweiten Typs 3 und andererseits an die dritte Elektrode 30 angeschlossen. Das Ferroelektret 6 ist über eine erste Grenzfläche 13 mit der Elektrode des ersten Typs 2 verbunden und gegenüber der Elektrode des zweiten Typs 3 isoliert. Geometrie, Lage und Abstände der Bauteile zueinander können wie bei den mit Bezug zu Fig. 1 und Fig. 2 beschriebenen Ausführungsformen sein.

Die Erfindung ist nicht auf die hier beschriebenen Ausführungsbeispiele und die darin hervorgehobenen Aspekte beschränkt. Vielmehr ist innerhalb des durch die Ansprüche angegebenen Bereichs eine Vielzahl von Abwandlungen möglich, die im Rahmen fachmännischen Handelns liegen.

**Patentansprüche**

1. Wandler (1) mit zumindest einer Elektrode eines ersten Typs (2), zumindest einer Elektrode eines zweiten Typs (3), zumindest einem Ferroelektret (6) und zumindest einem Elektret (4), wobei die Elektrode des ersten Typs (2) mit dem Ferroelektret (6) leitend verbunden ist, das Elektret (4) zur Elektrode des ersten Typs (2) durch zumindest einen Luftspalt (5) beabstandet ist und das Elektret (4) und das Ferroelektret (6) mit der Elektrode des zweiten Typs (3) leitend verbunden sind, **gekennzeichnet dadurch, dass** sich das Elektret (4), das Ferroelektret (6) und die Elektrode zweiten Typs auf derselben Seite der Elektrode ersten Typs befinden.

2. Wandler (1) mit einer Elektrode eines ersten Typs (2), zumindest einer Elektrode eines zweiten Typs (3), zumindest einem Ferroelektret (6) und zumindest einem Elektret (4), **gekennzeichnet dadurch, dass** das Ferroelektret (6) von der Elektrode des zweiten Typs (3) mittels einer Isolationsschicht (32) isoliert angeordnet ist und eine gemeinsame Grenzfläche (31) mit einer dritten Elektrode (30) aufweist, sodass das Elektret (4) und das Ferroelektret (6) miteinander in Reihe geschaltet sind.

3. Wandler (1) nach einem der Ansprüche 1 oder 2, **dadurch gekennzeichnet, dass** der Abstand (24) der Elektroden (2, 3) zueinander kleiner als 50 $\mu$m ist.

4. Wandler (1) nach einem der vorhergehenden Ansprüche, **dadurch gekennzeichnet, dass** der Wandler (1) radialsymmetrisch oder elliptisch um eine Hauptachse (9) ist.

5. Wandler (1) nach einem der vorhergehenden Ansprüche, **dadurch gekennzeichnet, dass** das Elektret (4) im Zentrum der Elektrode des ersten Typs (2) angeordnet ist.

6. Wandler (1) nach einem der Ansprüche 1 bis 4, **dadurch gekennzeichnet, dass** das Ferroelektret (6) im Zentrum der Elektrode des ersten Typs (2) angeordnet ist.

7. Wandler (1) nach einem der vorhergehenden Ansprüche mit einer Deckschicht (7), die auf der Elektrode des ersten Typs (2) aufliegt.

8. Wandler (1) nach Anspruch 7, **dadurch gekennzeichnet, dass** die Deckschicht (7) aus einem Glasfaserkunststoffverbund, einem Kohlefaserkunststoffverbund, aus Aluminium, aus einer Keramik oder aus einer Kombination daraus gefertigt ist.

9. Wandler (1) nach einem der vorhergehenden Ansprüche, **dadurch gekennzeichnet, dass** das Ferroelektret (6) aus einem porösen Polymermaterial, insbesondere aus PP, FEP, PTFA, PFA oder PTFE oder aus einer Kombination daraus gefertigt ist.

10. Wandler (1) nach einem der vorhergehenden Ansprüche, **dadurch gekennzeichnet, dass** das Elektret (4) aus einem porösen Polymermaterial, insbesondere aus FEP, PTFA, PFA oder PTFE oder aus einer Kombination daraus gefertigt ist.

11. Ultraschallwandler, insbesondere zur Verwendung in einem Ultraschallsystem eines Fahrzeugs, **gekennzeichnet durch** einen Wandler (1) nach einem der Ansprüche 1 bis 10.

12. Mikrofon, umfassend einen Wandler (1) nach einem der Ansprüche 1 bis 10, insbesondere einen Wandler nach Anspruch 5.


**Claims**

1. Transducer (1) having at least one electrode of a first type (2), at least one electrode of a second type (3), at least one ferroelectret (6) and at least one electret (4), wherein the electrode of the first type (2) is conductively connected to the ferroelectret (6), the electret (4) is spaced apart from the electrode of the first type (2) by at least one air gap (5) and the electret (4) and the ferroelectret (6) are conductively connected to the electrode of the second type (3), **characterized in that** the electret (4), the ferroelectret (6) and the electrode of the second type are located on the same side of the electrode of the first type.

2. Transducer (1) having an electrode of a first type (2), at least one electrode of a second type (3), at least one ferroelectret (6) and at least one electret (4), **characterized in that** the ferroelectret (6) is arranged insulated from the electrode of the second type (3) by means of an insulating layer (32) and has a common interface (31) with a third electrode (30), such that the electret (4) and the ferroelectret (6) are connected to one another in series.

3. Transducer (1) according to either of Claims 1 and 2, **characterized in that** the spacing (24) between the electrodes (2, 3) is smaller than 50 μm.

4. Transducer (1) according to one of the preceding claims, **characterized in that** the transducer (1) is radially symmetric or elliptic about a main axis (9).

5. Transducer (1) according to one of the preceding claims, **characterized in that** the electret (4) is arranged in the centre of the electrode of the first type (2).

6. Transducer (1) according to one of Claims 1 to 4, **characterized in that** the ferroelectret (6) is arranged in the centre of the electrode of the first type (2).

7. Transducer (1) according to one of the preceding claims, having a cover layer (7) on top of the electrode of the first type (2).

8. Transducer (1) according to Claim 7, **characterized in that** the cover layer (7) is made of a glass fibre reinforced polymer, a carbon fibre reinforced polymer, aluminium, a ceramic or a combination of these.

9. Transducer (1) according to one of the preceding claims, **characterized in that** the ferroelectret (6) is made of a porous polymer material, in particular PP, FEP, PTFA, PFA or PTFE or a combination of these.

10. Transducer (1) according to one of the preceding claims, **characterized in that** the electret (4) is made of a porous polymer material, in particular FEP, PTFA, PFA or PTFE or a combination of these.

11. Ultrasound transducer, in particular for use in an ultrasound system of a vehicle, **characterized by** a transducer (1) according to one of Claims 1 to 10.

12. Microphone, comprising a transducer (1) according to one of Claims 1 to 10, in particular a transducer according to Claim 5.

## Revendications

1. Convertisseur (1) comportant au moins une électrode d'un premier type (2), au moins une électrode d'un deuxième type (3), au moins un ferroélectret (6) et au moins un électret (4), dans lequel l'électrode du premier type (2) est reliée de manière conductrice au ferroélectret (6), l'électret (4) est espacé par au moins un entrefer (5) de l'électrode du premier type (2) et l'électret (4) et le ferroélectret (6) sont reliés de manière conductrice à l'électrode du deuxième type (3), **caractérisé en ce que** l'électret (4), le ferroélectret (6) et l'électrode du deuxième type se trouvent du même côté de l'électrode du premier type.

2. Convertisseur (1) comportant une électrode d'un premier type (2), au moins une électrode d'un deuxième type (3), au moins un ferroélectret (6), et au moins un électret (4), **caractérisé en ce que** le ferroélectret (6) est disposé de manière isolée de l'électrode du deuxième type (3) au moyen d'une couche d'isolation (32) et comporte une interface commune (31) avec une troisième électrode (30), de manière à ce que l'électret (4) et le ferroélectret (6) soient connectés l'un à l'autre en série.

3. Convertisseur (1) selon l'une quelconque des revendications 1 ou 2, **caractérisé en ce que** la distance (24) entre les électrodes (2, 3) est inférieure à 50 $\mu$m.

4. Convertisseur (1) selon l'une quelconque des revendications précédentes, **caractérisé en ce que** le convertisseur (1) est symétrique radialement ou elliptique autour d'un axe principal (9).

5. Convertisseur (1) selon l'une quelconque des revendications précédentes, **caractérisé en ce que** l'électret (4) est disposé au centre de l'électrode du premier type (2).

6. Convertisseur (1) selon l'une quelconque des revendications 1 à 4, **caractérisé en ce que** le ferroélectret (6) est disposé au centre de l'électrode du premier type (2).

7. Convertisseur (1) selon l'une quelconque des revendications précédentes, comportant une couche de recouvrement (7) qui est déposée sur l'électrode du premier type (2).

8. Convertisseur (1) selon la revendication 7, **caractérisé en ce que** la couche de recouvrement (7) est constituée d'un composite de fibres de verre-matière plastique, d'un composite de fibres de carbone-matière plastique, d'aluminium, d'une céramique, ou d'une combinaison de ceux-ci.

9. Convertisseur (1) selon l'une quelconque des revendications précédentes, **caractérisé en ce que** le ferroélectret (6) est constitué d'un matériau polymère poreux, notamment de PP, FEP, PTFA, PFA ou PTFE ou d'une combinaison de ceux-ci.

10. Convertisseur (1) selon l'une quelconque des revendications précédentes, **caractérisé en ce que** le l'électret (4) est constitué d'un matériau polymère poreux, notamment de FEP, PTFA, PFA ou PTFE ou d'une combinaison de ceux-ci.

11. Convertisseur d'ultrasons, notamment destiné à être utilisé dans un système à ultrasons d'un véhicule, **caractérisé par** un convertisseur (1) selon l'une quelconque des revendications 1 à 10.

12. Microphone, comprenant un convertisseur (1) selon l'une quelconque des revendications 1 à 10, notamment un convertisseur selon la revendication 5.

## Fig. 1

2 6    10    12    5    9    7    10    6    1

8 — U

3 13 14    11    4    15

## Fig. 2

2 16    12    5 10 6    9    10    7    1    25    23    24

8 — U

3    11    4    15 13 14    22    20 21

# Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006002067 A1
- EP 2339869 A1

- US 4183010 A
- DE 2253721